# EUROPEAN PATENT SPECIFICATION

(11) **EP 2 791 979 B1**
(45) Date of publication and mention of the grant of the patent: **29.04.2020**
(21) Application number: 12809942.1
(22) Date of filing: 13.12.2012
(51) Int. Cl.: H01L 31/0224, H01L 31/0216, H01L 31/05

(54) **PHOTOVOLTAIC CELL AND METHOD OF FORMING THE SAME**
PHOTOVOLTAISCHE ZELLE UND VERFAHREN ZU IHRER HERSTELLUNG
CELLULE PHOTOVOLTAÏQUE ET PROCÉDÉ DE FORMATION DE CELLE-CI

(30) Priority: 13.12.2011 US 201161569992 P
(43) Date of publication of application: 22.10.2014
(73) Proprietor: IMEC vzw, 3001 Leuven (BE)
(72) Inventor: BEAUCARNE, Guy Damien Serge, 3050 Oud-Heverlee (BE); HORZEL, Jörg, 79112 Freiburg (BE); POWELL, Nicholas, E., Midland, MI 48640 (US); TOUS, Loic, 3000 Leuven (BE); WOOD, Donald Adriaan, 7181 Arquennes (BE); ZAMBOVA, Adriana Petkova, Midland, MI 48640 (US)
(74) Representative: Murgitroyd & Company
(86) International application number: PCT/US2012/069492
(87) International publication number: WO 2013/090562

(56) References cited:
- WO-A1-2011/055887
- US-A- 5 376 403
- US-A1- 2008 196 757
- US-A1- 2010 252 616
- US-A1- 2012 222 738

## Description

### FIELD OF THE INVENTION

The present invention generally relates to a photovoltaic (PV) cell and to a method of forming the PV cell.

### BACKGROUND

Front surface metallization is an important aspect of photovoltaic (PV) cells which allows for collection and transport of charge carriers to busbars. The metallization is generally in the form of a grid, which includes narrow lines or "fingers" of conductive material which connect to wider busbars. Tabbing, e.g. ribbon, is soldered to the busbars to connect multiple PV cells together (e.g. in series). Typically, the grid is formed using pastes which include silver (Ag) as a primary component due to its excellent conductivity. Unfortunately, such metallization makes up a substantial portion of overall manufacturing cost due to reliance on Ag being present in both the fingers and busbars of the PV cells. As such, there remains an opportunity to provide improved PV cells and methods of forming the same.

### SUMMARY OF THE INVENTION

The present invention provides a photovoltaic (PV) cell and to a method of forming the PV cell as recited in the claims. Preferred embodiments of the invention are set forth in the dependent claims. The invention PV cell may be used for converting light of many different wavelengths into electricity.

The following documents may be useful in understanding the invention.

US2008/196757 relates to a photoelectric converter which generates carriers by photoelectric conversion. WO2011/055887 relates to a conductive adhesive, to a method for manufacturing same, and to an electronic device including the conductive adhesive, wherein the conductive adhesive comprises: conductive particles; an alloy powder having a low melting point and including an alloy formed from one or more metals selected from the group consisting of Sn and Ag, Cu, Bi, Zn, In, and Pb; a nanopowder; a first binder including a heat-curable resin; and a second binder including a rosin compound.

### BRIEF DESCRIPTION OF THE DRAWINGS

The present invention is further described in the following detailed description with reference to the accompanying drawings wherein:
Figure 1 is a front view of an embodiment of the PV cell including a base substrate, a coating layer, fingers, and a pair of busbars;
Figure 2 is a partial cross-sectional side view taken along line 2-2 of Figure 1 illustrating an upper doped region of the base substrate, the coating layer, fingers, and one of the busbars;
Figure 3 is a cross-sectional side view of an embodiment of the PV cell illustrating upper and lower doped regions of a base substrate, a coating layer, fingers, a busbar, and an electrode;
Figure 4 is a partial cross-sectional perspective view of an embodiment of the PV cell illustrating an upper doped region of a base substrate, a coating layer, fingers, and a pair of busbars;
Figure 5 is a partial cross-sectional perspective view of a PV cell illustrating an upper doped region of a base substrate, a textured surface, a coating layer, and a pair of fingers extending into the base substrate;
Figure 6 is a flow chart illustrating steps of a method of forming the PV cell;
Figure 7 is a flow chart illustrating steps of a method of forming the PV cell;
Figure 8 is a diagram illustrating polymer curing and solder flow of a composition useful for forming the busbars of the PV cell;
Figure 9 is a partial cross-sectional perspective view of a PV cell illustrating an upper doped region of a base substrate, a coating layer, fingers, a pair of busbars, and a pair of tabbing ribbons with one of the tabbing ribbons being disposed on one of the busbars;
Figure 10 is a schematic front view of an embodiment of the PV cell including a passivation layer, discontinuous-fingers, and a busbar;
Figure 11 is a schematic front view of an embodiment of the PV cell including a passivation layer, discontinuous-fingers, supplemental fingers, and a busbar;
Figure 12 is a schematic front view of an embodiment of the PV cell including a passivation layer, fingers, a busbar, and supplemental busbar pads;
Figure 13 is a schematic front view of an embodiment of the PV cell including a passivation layer, fingers, a pair of busbars, and a supplemental busbar;
Figure 14 is a schematic front view of an embodiment of the PV cell including a passivation layer, fingers having pads, and a busbar;
Figure 15 is a schematic front view of an embodiment of the PV cell including a passivation layer, fingers having hollow pads, and a busbar;
Figure 16 is a schematic front view of an embodiment of the PV cell including a passivation layer, discontinuous-fingers, supplemental fingers, and a busbar;
Figure 17 is a box graph illustrating short-circuit current density (J_{SC}) of comparative and invention examples;
Figure 18 is a box graph illustrating open-circuit voltage (V_{OC}) of comparative and invention examples;
Figure 19 is a box graph illustrating cell efficiency (NCell) of comparative and invention examples
Figure 20 is a box graph illustrating efficiency percentage of comparative and invention examples;
Figure 21 is another box graph illustrating J_{SC} of comparative and invention examples;
Figure 22 is another box graph illustrating V_{OC} of comparative and invention examples;
Figure 23 is a cross-sectional optical microscopy photograph (converted to drawing form) illustrating a tabbed busbar of the invention, a finger, and a passivation layer;
Figure 24 is a line graph illustrating J_{SC} of comparative and invention examples after damp heat aging;
Figure 25 is a line graph illustrating V_{OC} of comparative and invention examples after damp heat aging; and
Figure 26 is a line graph illustrating sheet resistivity (rs) of comparative and invention examples after damp heat aging.

### DETAILED DESCRIPTION OF THE INVENTION

Referring to the Figures, wherein like numerals indicate like parts throughout the several views, an embodiment of the photovoltaic (PV) cell is generally shown at **20.** PV cells **20** are useful for converting light of many different wavelengths into electricity. As such, the PV cell **20** can be used for a variety of applications. For example, a plurality of PV cells **20** can be used in a solar module (not shown). The solar module can be used in a variety of locations and for a variety of applications, such as in residential, commercial, or industrial, applications. For example, the solar module can be used to generate electricity, which can be used to power electrical devices (e.g. lights and electric motors), or the solar module can be used to shield objects from sunlight (e.g. shield automobiles parked under solar modules that are disposed over parking spaces). The PV cell **20** is not limited to any particular type of use. The figures are not drawn to scale. As such, certain components of the PV cell **20** may be larger or smaller than as depicted.

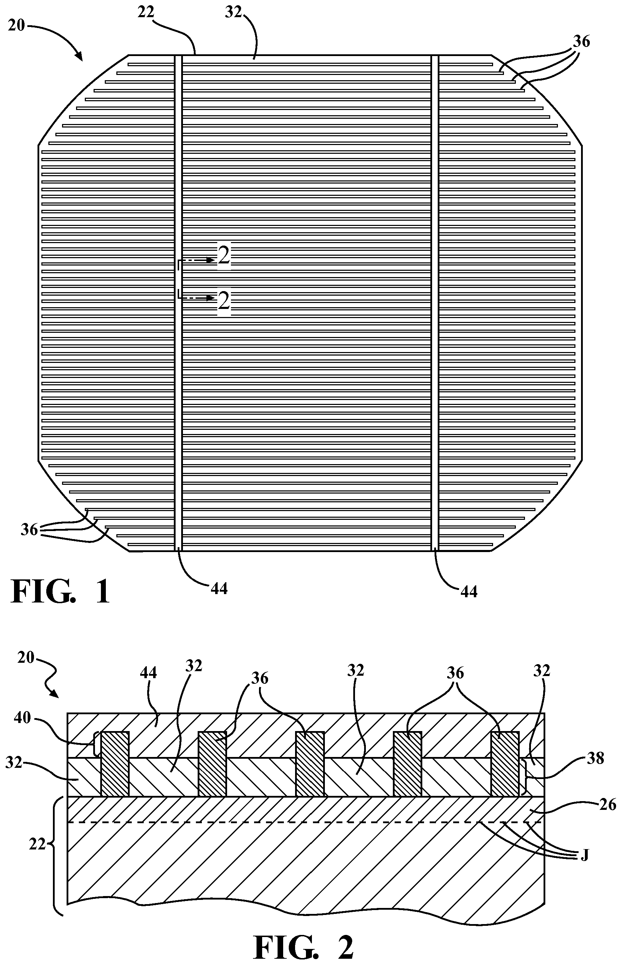

Referring to Figure 1, the PV cell **20** is shown in a square configuration with rounded corners, i.e., a pseudo-square. While this configuration is shown, the PV cell **20** may be configured into various shapes. For example, the PV cell **20** may be a rectangle with corners, a rectangle with rounded or curved corners, a circle, etc. The PV cell **20** is not limited to any particular shape. The PV cell **20** can be of various sizes, such as 4 by 4 inch (10.2 by 10.2 cm) squares, 5 by 5 inch (12.7 by 12.7 cm) squares, 6 by 6 inch (15.2 by 15.2 cm) squares, etc. The PV cell **20** is not limited to any particular size.

Referring to Figure 2, the PV cell **20** comprises a base substrate **22.** The base substrate **22** comprises silicon. The silicon may also be referred to in the art as a semiconductor material. Various types of silicon can be utilized, such as monocrystalline silicon, polycrystalline silicon, amorphous silicon, or combinations thereof. In certain examples, the base substrate **22** comprises crystalline silicon, e.g. monocrystalline silicon. The PV cell **20** is generally referred to in the art as a wafer type PV cell **20.** Wafers are thin sheets of silicon that are typically formed from mechanically sawing the wafer from a single (mono) crystal or multicrystal silicon ingot. Alternatively, wafers can be formed from casting silicon, from epitaxial liftoff techniques, pulling a silicon sheet from a silicon melt, etc.

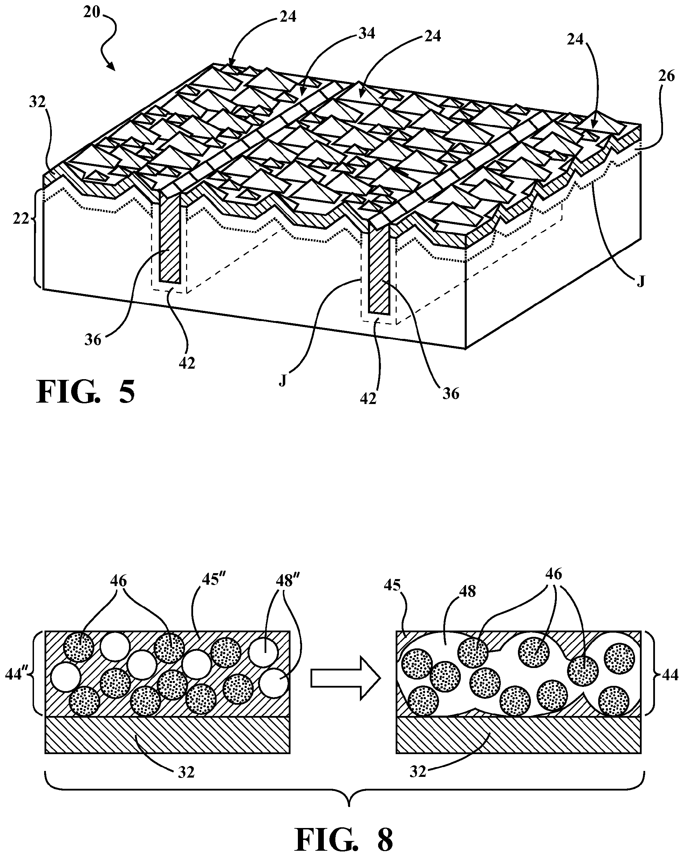

The base substrate **22** is generally planar, but may also be non-planar. The base substrate **22** can include a textured surface **24.** The textured surface **24** is useful for reducing reflectivity of the PV cell **20.** The textured surface **24** may be of various configurations, such as pyramidal, inverse pyramidal, random pyramidal, isotropic, etc. An example of texturing is illustrated in Figure 5. Texturing can be imparted to the base substrate **22** by various methods. For example, an etching solution can be used for texturing the base substrate **22.** The PV cell **20** is not limited to any particular type of texturing process. The base substrate **22,** e.g. wafer, can be of various thicknesses, such as from about 1 to about 1000, about 75 to about 750, about 75 to about 300, about 100 to about 300, or about 150 to about 200, µm thick on average.

The base substrate **22** is typically classified as a p-type or an n-type, silicon substrate (based on doping). The base substrate **22** includes an upper (or front side) doped region **26,** which is generally the sun up/facing side. The upper doped region **26** may also be referred to in the art as a surface emitter, or active semiconductor, layer. In certain embodiments, the upper doped region **26** of the base substrate **22** is an n-type doped region **26** (e.g. an n⁺ emitter layer) such that a remainder of the base substrate **22** is generally p-type. In other embodiments, the upper doped region **26** of the base substrate **22** is a p-type doped region **26** (e.g. a p⁺ emitter layer) such that a remainder of the base substrate **22** is generally n-type. The upper doped region **26** can be of various thicknesses, such as from about 0.1 to about 5, about 0.3 to about 3, or about 0.4, µm thick on average. The upper doped region **26** may be applied such that doping under the fingers **36** (described below) is increased, such as in "selective emitter" technologies.

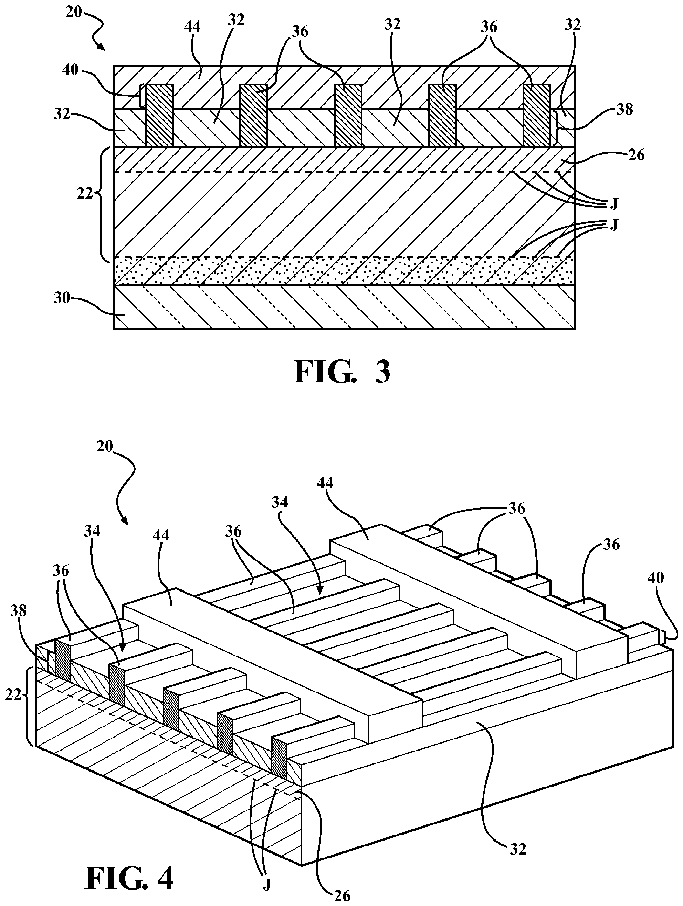

Referring to Figure 3, the base substrate **22** typically includes a lower doped region **28** opposite the upper doped region **26.** The lower doped region **28** may also be referred to in the art as a back surface field (BSF). Typically, one of the doped regions, e.g. the upper **26,** is an n-type and the other doped region, e.g. the lower **28,** is a p-type. The opposite arrangement may also be used, i.e., the upper **26** is a p-type and the lower **28,** is an n-type. Such configurations, where the oppositely doped region **26,28** interfaces, are referred to in the art as p-n junctions (**J**) and are useful for photo-excited charge separation provided there is at least one positive (p) region and one negative (n) region. Specifically, when two regions of different doping are adjacent, a boundary defined there between is generally referred to in the art as a junction. When the doping are of opposite polarities then the junction (**J**) is generally referred to as a p-n junction (**J**). When doping is merely of different concentrations, the "boundary" may be referred to as an interface, such as an interface between like regions, e.g. p and p⁺ regions. As shown generally in the Figures, such junctions (**J**) may be optional, depending on what type of doping is utilized in the base substrate **22.** The PV cell **20** is not limited to any particular number or location of junction(s) (**J**). For example, the PV cell **20** may only include only one junction (**J**), at the front or rear.

Various types of dopants and doping methods can be utilized to form the doped regions **26,28** of the base substrate **22.** For example, a diffusion furnace can be used to form an n-type doped region **26,28** and a resulting n-p (or "p-n") junction (**J**). An example of a suitable gas is phosphoryl chloride (POCl₃). In addition or alternate to phosphorus, arsenic can also be used to form n-type regions **26,28.** At least one of the periodic table elements from group V, e.g. boron or gallium, can be used to form p-type regions **26,28.** The PV cell **20** is not limited to any particular type of dopant or doping process.

Doping of the base substrate **22** can be at various concentrations. For example, the base substrate **22** can be doped at different dopant concentrations to achieve resistivity of from about 0.5 to about 10, about 0.75 to about 3, or about 1, Ω•cm (Ω.cm). The upper doped region **26** can be doped at different dopant concentrations to achieve sheet resistivity of from about 50 to about 150, or about 75 to about 125, or about 100, Ω/□ (Ω per square). In general, a higher concentration of doping may lead to a higher open-circuit voltage (V_{OC}) and lower resistance, but higher concentrations of doping can also result in charge recombination depleting cell performance and introduce defect regions in the crystal.

Typically, there is an electrode **30** disposed on the lower doped region **28,** opposite the upper doped region **26.** The electrode **30** may cover the entire lower doped region **28** or only a portion thereof. If the later, typically a passivation layer (not shown), e.g. a layer of SiNₓ, is used to protect exposed portions of the lower doped region **28,** but the passivation layer is not used between the electrode **30** and the portion of lower doped region **28** in direct physical and electrical contact. The electrode **30** may take the form of a layer, a layer having localized contacts, or a contact grid comprising fingers and busbars. Examples of suitable configurations include p-type base configurations, n-type base configurations, PERC or PERL type configurations, bifacial BSF type configurations, heterojunction with intrinsic thin layer (HIT) configurations, etc. The PV cell **20** is not limited to any particular type of electrode **30** or electrode configuration. Where the lower doped region **28** is a p-type, the electrode **30** typically comprises at least one of the periodic table elements of group III, e.g. aluminum (Al). Al can be used as a p-type dopant. For example, an Al paste can be applied to the base substrate **22** and then fired to form the electrode **30,** while also forming the lower p⁺-type doped region **28.** The Al paste can be applied by various methods, such as by a screen printing process. Other suitable methods are described below.

As best shown in Figures 2 and 3, a coating layer **32** is disposed on the upper doped region **26.** The coating layer **32** is useful for increasing sunlight absorption by the PV cell **20,** e.g. by reducing reflectivity of the PV cell **20,** as well as generally improving wafer lifetime through surface and bulk passivation. The coating layer **32** has an outer surface **34** opposite the upper doped region **26.** The coating layer **32** may also be referred to in the art as a dielectric passivation, or anti-reflective coating (ARC), layer.

The coating layer **32** may be formed from various materials. In certain embodiments, the coating layer **32** comprises SiOₓ, ZnS, MgFₓ, SiNₓ, SiCNₓ, AlOₓ, TiO₂, a transparent conducting oxide (TCO), or combinations thereof. Examples of suitable TCOs include doped metal oxides, such as tin-doped indium oxide (ITO), aluminum-doped zinc-oxide (AZO), indium-doped cadmium-oxide, fluorine-doped tin oxide (FTO), or combinations thereof. In certain embodiments, the coating layer **32** comprises SiNₓ. Employing SiNₓ is useful due to its excellent surface passivation qualities. Silicon nitride is also useful for preventing carrier recombination at the surface of the PV cell **20.**

The coating layer **32** may be formed from two or more sub-layers (not shown), such that the coating layer **32** may also be referred to as a stack. Such sub-layers can include a bottom ARC (B-ARC) layer and/or a top ARC (T-ARC) layer. Such sub-layers can also be referred to as dielectric layers, and be formed from the same or different material. For example, there may be two or more sub-layers of SiNₓ; a sub-layer of SiNₓ and a sub-layer of AlOₓ; etc.

The coating layer **32** can be formed by various methods. For example, the coating layer **32** can be formed by using a plasma-enhanced chemical vapor deposition (PECVD) process. In embodiments where the coating layer **32** comprises SiNₓ, silane, ammonia, and/or other precursors can be used in a PECVD furnace to form the coating layer **32.** The coating layer **32** can be of various thicknesses, such as from about 10 to about 150, about 50 to about 90, or about 70, nm thick on average. Sufficient thickness can be determined by the refractive indices of the coating material and base substrate **22.** The PV cell **20** is not limited to any particular type of coating process.

A plurality of fingers **36** are spaced from each other and disposed in the coating layer **32.** Each of the fingers **36** has a lower portion **38** in electrical contact with the upper doped region **26** of the base substrate **22.** The lower portion **38** in actual electrical contact may be quite small, such as tips/ends of the fingers **36.** Each of the fingers **36** also has an upper portion **40** opposite the lower portion **38** extending outwardly through the outer surface **34** of the coating layer **32.** The fingers **36** are generally disposed in a grid pattern, as best shown in Figures 1 and 4. Typically, the fingers **36** are disposed such that the fingers **36** are relatively narrow while being thick enough to minimize resistive losses. Orientation and number of the fingers **36** may vary.

As shown in Figure 5, the fingers **36** extend downwardly into the base substrate **22.** Such configurations may be referred to in the art as "buried contact cells". Grooves can be formed into the base substrate **22** by lasers such that the PV cell **20** may be referred to in the art as a laser grooved buried grid (LGBG) PV cell **20.** Typically, such PV cells **20** include local "selective emitter" layers **42** around the grooves, such as n⁺⁺ emitter layers. Other methods can also be used to form the grooves besides lasers, such as sawing, etching, etc.

The fingers **36** can be of various widths, such as from about 10 to about 200, about 70 to about 150, about 90 to about 120, or about 100, µm wide on average. The fingers **36** can be spaced various distances apart from each other, such as from about 1 to about 5, about 2 to about 4, or about 2.5, mm apart on average. The fingers **36** can be of various thicknesses, such as from about 5 to about 50, about 5 to about 25, or about 10 to about 20, µm thick on average.

Each of the fingers **36** comprises a first metal, which is present in each of the fingers **36** in a majority amount. The first metal may comprise various types of metals. In certain embodiments, the first metal comprises silver (Ag). In other embodiments, the first metal comprises copper (Cu). By "majority amount", it is generally meant that the first metal is the primary component of the fingers **36,** such that it is present in an amount greater than any other component that may also be present in the fingers **36.** Such a majority amount of the first metal, e.g. Ag, is generally greater than about 35, greater than about 45, or greater than about 50, weight percent (wt%), each based on the total weight of the finger **36.**

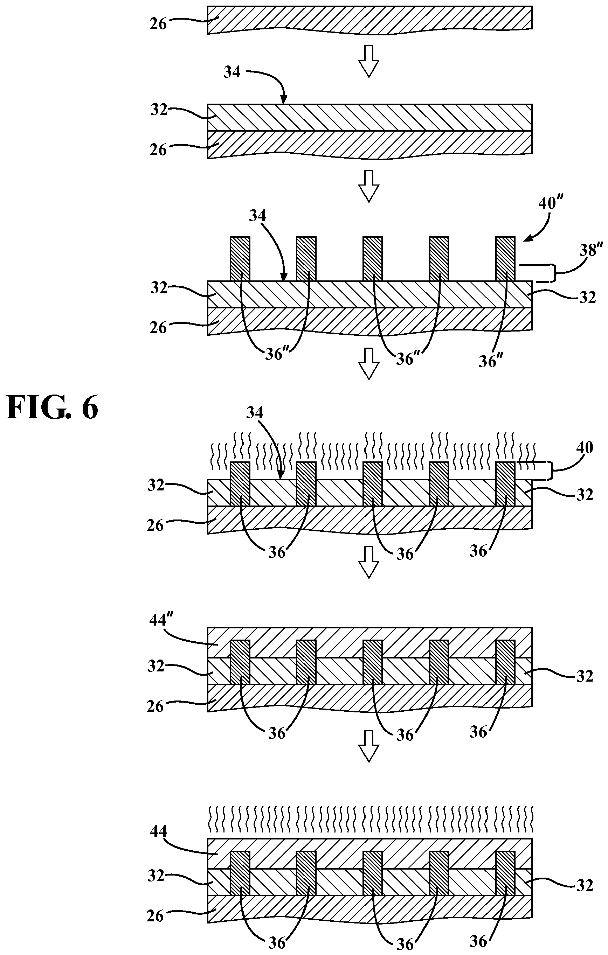

The fingers **36** can be formed by various methods. Suitable methods include sputtering; vapor deposition; strip or patch coating; ink-jet printing, screen printing, gravure printing, letter printing, thermal printing, dispensing or transfer printing; stamping; electroplating; electroless plating; or combinations thereof. One type of method is generally referred to as an etching/firing process, is described below and illustrated in Figure 6. Suitable compositions for forming the fingers **36** are described further below.

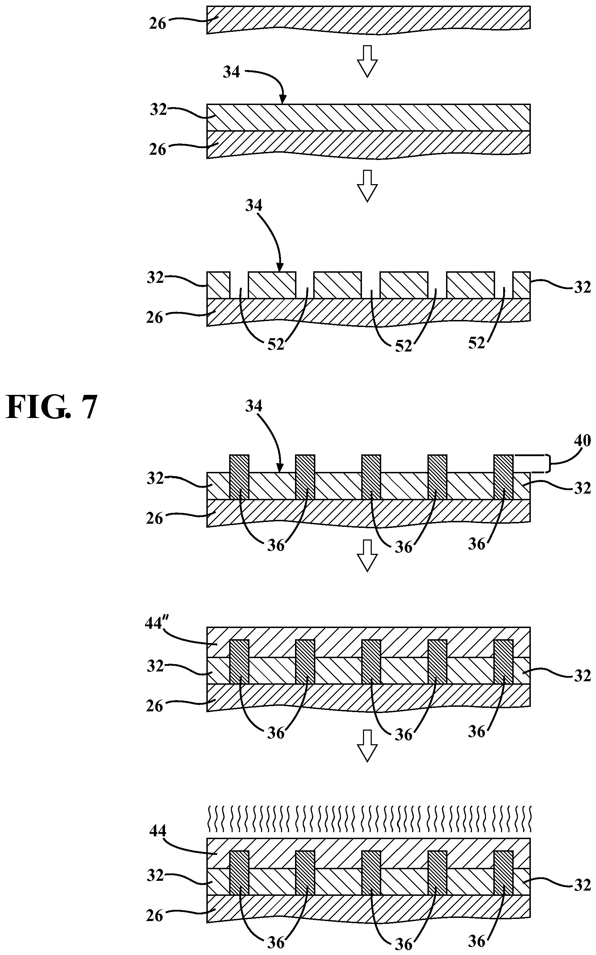

In certain examples, the fingers **36** are formed by a plating process (rather than an etching/firing process). In these examples, the fingers **36** generally comprise a plated or stacked structure (not shown). For example, the fingers **36** can comprise two or more of the following layers: nickel (Ni), Ag, Cu, and/or tin (Sn). The layers can be in various orders, provided the Cu layer (if present) is not in direct physical contact with the upper doped region **26** of the base substrate **22.** Typically, a seed layer comprising Ag or a metal other than Cu, e.g. Ni, is in contact with the upper doped region **26.** In certain cases, the seed layer comprises Ni silicide. Subsequent layers are then disposed on the seed layer to form the fingers **36.** When the fingers **36** include Cu, a passivation layer such as Sn or Ag is disposed over the Cu layer to prevent oxidation. In certain examples, the lower portions **38** of the fingers **36** comprise Ni, the upper portions **40** of the fingers **36** comprise Sn, and Cu is disposed between the Ni and Sn. In this way, the Cu is protected from oxidation by the Ni, Sn, and surrounding coating layer **32.** Such layers can be formed by various methods, such as aerosol printing and firing; electrochemical deposition; etc. One method is described below and illustrated in Figure 7. The PV cell **20** is not limited to any particular type of process of forming the fingers **36.**

A busbar **44** is spaced from the upper doped region **26** of the base substrate **22.** As shown in Figures 1 and 4, the PV cell **20** generally has two busbars **44.** The PV cell **20** may have more than two busbars **44** (not shown), such as three busbars **44,** four busbars **44,** six busbars **44,** etc. Each busbar **44** is in electrical contact with the upper portions **40** of the fingers **36.** The busbars **44** are useful for collecting current from the fingers **36** which have collected current from the upper doped region **26.** As best shown in Figure 4, each of the busbars **44** is disposed on the outer surface **34** of the coating layer **32** and around each of the fingers **36** to provide intimate physical and electrical contact to the upper portions **40** of the fingers **36.** Typically, the busbar **44** is transverse the fingers **36.** Said another way, the busbar **44** can be at various angles relative to the fingers **36,** including perpendicular. The upper portion **40** in actual physical/electrical contact may be small, such as just tips/ends of the fingers **36.** Such contact places the busbar **44** in position for carrying current directly from the fingers **36.** The fingers **36** themselves are in intimate physical and electrical contact with the upper doped region **26** of the base substrate **22.**

The busbar **44** can be of various widths, such as from about 0.5 to about 10, about 1 to about 5, or about 2, mm wide on average. The busbar **44** can be of various thicknesses, such as from about 0.1 to about 500, about 10 to about 250, about 30 to about 100, or about 30 to about 50, µm thick on average. The busbars **44** can be spaced various distances apart. Typically, the busbars **44** are spaced to divide lengths of the fingers 36 into -equal regions, e.g. as shown in Figure 1.

The busbar **44** comprises a second metal, which is present in the busbar **44** in a majority amount. The "second" is used to differentiate the metal of the busbar **44** from the "first" metal of the fingers **36,** and does not imply quantity or order. The second metal may comprise various types of metals. In certain embodiments, the second metal of the busbar **44** is the same as the first metal of the fingers **36.** For example, both the first and second metals can be Cu. In other embodiments, the second metal of the busbar **44** is different from the first metal of the fingers **36.** In these embodiments, the first metal typically comprises Ag and the second metal typically comprises Cu. In other embodiments, the second metal comprises Ag. By "majority amount", it is generally meant that the second metal is the primary component of the busbar **44,** such that it is present in an amount greater than any other component that may also be present in the busbar **44.** Such a majority amount of the second metal, e.g. Cu, is generally greater than about 25, greater than about 30, greater than about 35, or greater than about 40, wt%, each based on the total weight of the busbar **44.**

The busbar **44** also generally comprises a third metal. The third metal is different from the first metal of the fingers **36.** The third metal is also different from the second metal of the busbar **44.** Typically, the metals are different elements, rather than just different oxidation states of the same metal. The "third" is used to differentiate the metal of the busbar **44** from the "first" metal of the fingers **36,** and does not imply quantity or order. The third metal melts at a lower temperature than melting temperatures of the first ands second metals. Typically, the third metal has a melting temperature of no greater than about 300, no greater than about 275, or no greater than about 250, °C. Such temperatures are useful for forming the busbar **44** at low temperatures as described further below.

In certain embodiments, the third metal comprises solder. The solder can comprise various metals or alloys thereof. One of these metals is typically Sn, lead, bismuth, cadmium, zinc, gallium, indium, tellurium, mercury, thallium, antimony, Ag, selenium, and/or an alloy of two or more of these metals. In certain embodiments, the solder comprises a Sn alloy, such as a eutectic alloy, e.g. Sn63/Pb37. In certain examples, the solder powder comprises two different alloys, such as a Sn alloy and a Ag alloy, alternatively more than two different alloys. The third metal can be present in the busbar **44** in various amounts, typically in an amount less than the second metal. The busbar **44** typically comprises at least one a polymer in addition to the second and third metals, as described further below.

As best shown in Figure 4, the upper doped region **26** of the base substrate **22** is free of (direct) physical contact with the busbar **44.** Specifically, the coating layer **32** serves as a "barrier" between the busbar **44** and upper doped region **26.** Without being bound or limited by any particular theory, it is believed that physical separation of the busbar **44** and the upper doped region **26** is beneficial for at least two reasons. First, such separation prevents diffusion of the second metal, e.g. Cu, into the upper doped region **26.** It is believed that preventing such diffusion prevents the upper doped region **26,** e.g. the p-n junction (**J**), from being shunted by the second metal of the busbar **44.** Second, such physical separation is believed to reduce minority carrier recombination at the metal and silicon interfaces. It is believed that by reducing the area of metal/silicon interface, loss due to recombination is generally reduced and open-circuit voltage (V_{OC}) and short-circuit current density (J_{SC}) are generally improved. The area is reduced due to the coating layer **32** being disposed between much of the busbar **44** and the upper doped region **26,** with the fingers **36** being the only metal components in contact with the upper doped region **26** of the base substrate **22.**

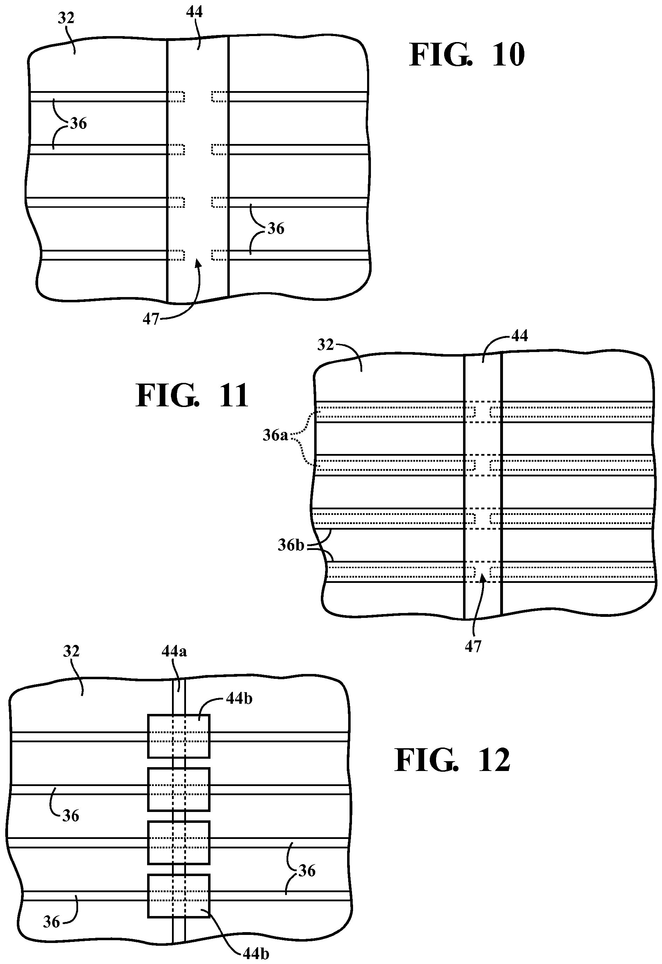

The PV cell **20** of Figure 10 is similar to that of Figure 1, but includes discontinuous-fingers **36.** The busbar **44** is disposed over a gap **47** defined between the fingers **36.** The gap **47** can be of various widths, provided the busbar **44** is in electrical contact with the fingers **36.** The fingers **36** may comprise a majority of one metal, e.g. Ag, whereas the busbar **44** another metal, e.g. Cu. By having gaps **47,** cost of manufacture can be reduced (such as by reducing the total amount of Ag utilized), and/or adhesion may be positively impacted.

The PV cell **20** of Figure 11 is similar to that of Figure 10, but further includes supplemental fingers **36b** disposed over the fingers **36a.** The supplemental fingers **36b** may comprise the same material as the busbar **44,** e.g. Cu, or a different material. The supplemental fingers **36b** and the busbar **44** may be separate (e.g. one lying over the other) or unitary. By utilizing the supplemental fingers **36b,** the size of the fingers **36a** (e.g. Ag fingers) can be reduced, which can reduce cost of manufacture and/or improve adhesion.

The PV cell **20** of Figure 12 includes fingers **36,** busbar **44a,** and supplemental busbar pads **44b** disposed over the fingers **36** and busbar **44a.** The fingers **36** and busbar **44a** may be separate of unitary. The fingers **36** and busbar **44a** may comprise the same majority metal, e.g. Ag, or be different than each other. The busbar pads **44b** can comprise Cu or another metal, e.g. when formed from the invention composition. By utilizing the busbar pads **44b,** the size of the busbar **44a** (e.g. Ag busbar) can be reduced.

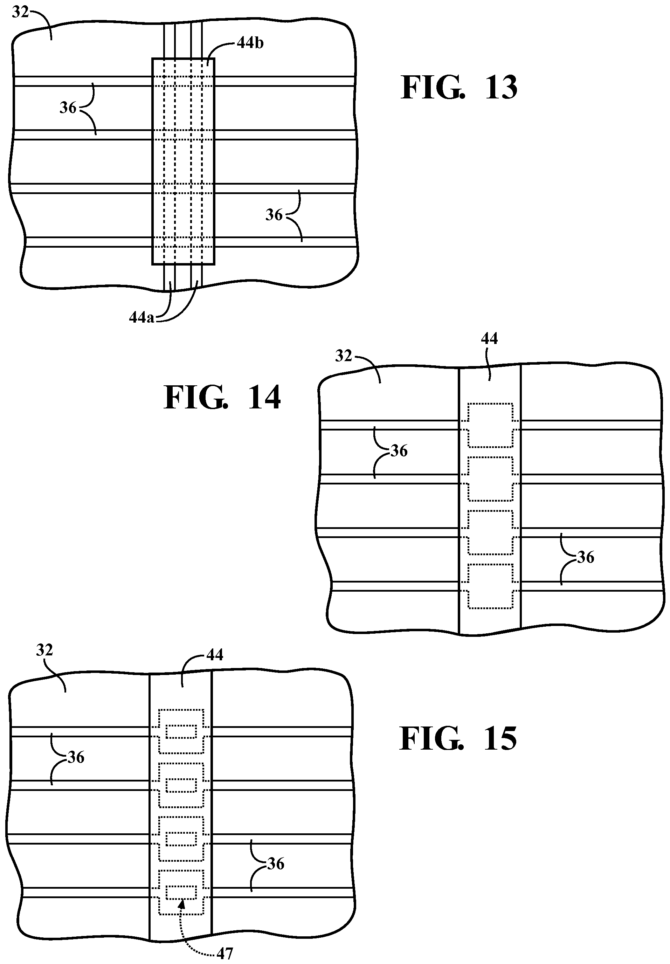

The PV cell **20** of Figure 13 is similar to that of Figures 10 and 12, but includes a pair of busbars **44a** and a supplemental busbar **44b** disposed over the busbars **44a.** The fingers **36** and busbars **44a** can be separate or unitary. The fingers **36** and busbar **44a** may comprise the same majority metal, e.g. Ag, or be different than each other. The supplemental busbar **44b** can comprise Cu or another metal. By utilizing the supplemental busbar **44b,** the size of the busbars **44a** can be reduced.

The PV cells **20** of Figures 14 and 15 are similar to that of Figure 10, but include fingers **36** having pads in place of the gaps **47.** The padded fingers **36** can help to improve electrical contact to the busbar **44,** adhesion, while reducing the amount of Ag used and reducing manufacturing cost. The fingers **36** of Figure 15 have hollow pads, i.e., internal gaps **47,** which can reduce cost of manufacture and positively impact adhesion. A portion of the busbar **44** may be disposed in the gaps **47** of the hollow padded fingers **36.**

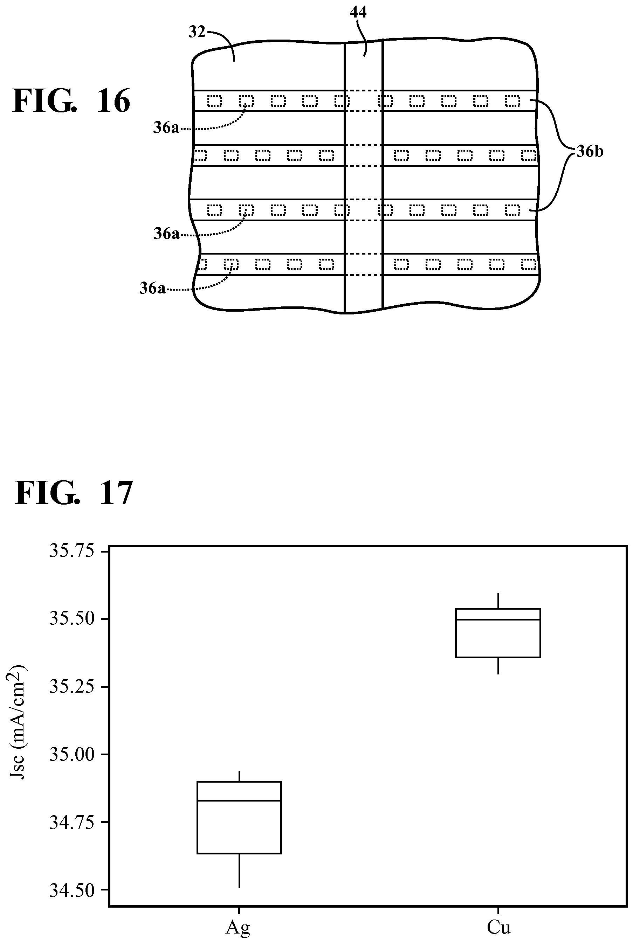

The PV cell **20** of Figure 16 is similar to that of Figure 10, but includes discontinuous-fingers **36a** with supplemental fingers **36b** disposed thereon. The discontinuous-fingers **36a** can be in various shapes, such as rectangles, squares, dots, or combinations thereof. Such fingers **36a** can be plated, printed, or formed in another manner. A plurality of gaps **47** are defined by the discontinuous-fingers **36a.** The supplemental fingers **36b** and the busbar **44** may be separate or unitary. By utilizing the discontinuous-fingers **36a** and supplemental fingers **36b,** cost of manufacture can be reduced. The discontinuous-fingers **36a** typically contact the emitter **26** while the supplemental fingers **36b** and busbar **44** carry current.

The present invention also provides a method of forming the PV cell **20.** The method includes the step of applying a composition to the upper portions **40** of the fingers **36** to form a layer **44".** As used herein, a quotation mark (") generally indicates a different state of the respective component, such as prior to curing, prior to sintering, etc. The composition can be applied by various methods, as alluded to above. In certain embodiments, the composition is printed on at least a portion of the upper portions **40** of the fingers **36** to form a layer **44".** Various types of deposition methods can be utilized, such as printing through screen or stencil, or other methods such as aerosol, ink jet, gravure, or flexographic, printing. In certain examples, the composition is screen printed directly onto portions of the coating layer **32** and the upper portions **40** of the fingers **36.**

As shown in Figures 6 and 7, the upper doped region **26** of the base substrate **22** is free of (direct) physical contact with the layer **44".** The composition can be applied to the coating layer **32** and around each of the fingers **36** to make direct physical and electrical contact to the upper portions **40** of the fingers **36** with the layer **44".**

As alluded to above, the composition used to form the layer **44"** (eventually the busbar **44**) comprises the second metal present in the composition in a majority amount. Such amounts are as described above. Typically, the second metal is Cu. The composition also comprises the third metal. Typically, the third metal is solder, e.g. Sn63Pb37. The composition is generally free of components capable of etching into the cover layer, e.g. fritted glass, such that the cover sheet is not etched by the composition.

Various types of Cu pastes can be used as the composition to form the layer **44".** In certain embodiments, the composition comprises a copper powder as the second metal, and a solder powder as the third metal. The solder powder melts at lower temperature than melting temperature of the copper powder. The composition further comprises a polymer, or a monomer which is polymerisable to yield a polymer. The polymer is generally a thermosetting resin, such as an epoxy, an acrylic, a silicone, a polyurethane, or combinations thereof. The composition can further comprise a cross-linking agent for the polymer and/or a catalyst for promoting cross-linking of the polymer. The cross-linking agent can be selected from carboxylated polymers, dimer fatty acids and trimer fatty acids. The composition may also include a solvent to adjust rheology. Other additives can also be included, such as dicarboxylic and/or monocarboxylic acids, adhesion promoters, defoamers, fillers, etc. Further examples of suitable Cu pastes, and components thereof, useful as the composition are disclosed in U.S. Patent No. 7,022,266 to Craig, and in U.S. Patent No. 6,971,163 to Craig et al.,.

The method further comprises the step of heating the layer **44"** to a temperature of no greater than about 300 °C to form the busbar **44.** Heating is indicated in Figures 6 and 7 by wavy vertical lines. The layer **44"** is generally heated to a temperature of from about 150 to about 300, about 175 to about 275, about 200 to about 250, or about 225, °C. In certain embodiments, the layer **44"** is heated at about 250 °C or less to form the busbar **44.** Such temperatures generally sinter the third metal (e.g. solder) in the layer **44",** but do not sinter the second metal (e.g. Cu) in the layer **44"** to form the busbar **44.** Such heating may also be referred to in the art as reflow or sintering.

Referring to Figure 8, it is believed that the particles of solder **48"** sinter and coat particles of Cu **46** during heating of the layer **44"** to form the busbar **44.** Also during this time, the polymer **45"** can lose volatiles and crosslinks to a final cured state **45.** Such coating enables the solder coated Cu **46** to carry current of the PV cell **20,** and can also prevent oxidation of the Cu **46.** Due to the lower temperatures, the Cu **46** does not generally sinter during the heating, based on it having a melting temperature of about 1000 °C. The low temperature of this heating step generally allows for the use of temperature sensitive base substrates **22,** e.g. amorphous silicon.

The layer **44"** can be heated for various amounts of time to form the busbar **44.** Typically, the layer **44"** is heated only for the period of time required for the busbar **44** to form. Such times can be determined via routine experimentation. An inert gas, e.g. a nitrogen (N₂) gas blanket, can be used to prevent premature oxidation of the Cu **46** prior to being coated with the solder **48".** Unnecessarily overheating the busbar **44** for longer periods of time may damage the upper doped region **26** or other components of the PV cell **20** including the busbar **44.**

Referring to Figure 6, prior to forming the busbar 44, the method comprises the step of applying a coating composition to the upper doped region **26** of the base substrate **22** to form the coating layer **32.** The coating composition can comprise various components, such as those suitable for forming the coating layers **32** described above. The coating composition can be applied by various methods, as introduced above. For example, a PECVD process can be utilized. In embodiments where the coating layer **32** comprises SiNₓ, silane, ammonia, and/or other precursors can be used in a PECVD furnace to form the coating layer **32.**

The method further comprises the step of applying a metallic composition to portions of the coating layer **32** in a finger pattern corresponding to the fingers **36** to be formed. As shown in Figure 6, each of the finger patterns **36"** has their lower portion **38"** in contact with the coating layer **32** and their upper portion **40"** spaced from the coating layer **32** after application. The metallic composition can be applied by various methods, as alluded to above. In certain examples, the metallic composition is printed on portions of the coating layer **32** to form the finger patterns **36".** Various types of printing methods can be utilized, such as screen, stencil, aerosol, ink jet, gravure, or flexographic, printing. In certain embodiments, the metallic composition is screen printed directly onto the coating layer **32** to form the finger patterns **36".** In other examples, the metallic composition is electrochemically deposited on portions of the coating layer **32** to form the finger patterns **36".** Other suitable methods are described above.

The metallic composition comprises the first metal present in the metallic composition in a majority amount. Such amounts are as described above. Typically, the first metal is Ag. The metallic composition typically includes one or more components for etching into the coating layer **32.** Such components generally include fritted leaded glass. Other components may also be used in addition or alternate to leaded glass, such as unleaded or low leaded glass.

Various types of fritted Ag pastes can be used as the metallic composition. Such pastes generally include an organic carrier. Upon high temperature processing or "firing", the organic carrier burns out and is removed from the bulk composition. Ag particles are dispersed throughout the carrier. A solvent may be included to adjust rheology of the paste. The fritted paste includes glass frits, which generally comprises PbO, B₂O₃, and SiO₂. The method is not limited to any particular fritted Ag paste, provided the paste can etch through the cover sheet at elevated temperatures, as described below. Examples of suitable fritted Ag pastes are commercially available from Ferro of Mayfield Heights, OH and Heraeus Materials Technology, LLC of West Conshohocken, PA.

The method further comprises the step of heating the finger patterns **36"** to form the fingers **36.** The finger patterns **36"** are generally heated to a temperature of from about 250 to about 1000, from about 500 to about 900, or about 720, °C. Such temperatures generally sinter the first metal in the finger patterns **36"** to form the fingers **36.** This heating step is generally much higher in temperature relative to the heating step used to form the busbar **44.** In addition, the glass frit allows for the finger patterns **36"** to etch through the coating layer **32** and upon cooling, phase separate. This allows for direct electrical contact of the fingers **36** to the upper doped region **26** of the base substrate **22.** Such heating may also be referred to in the art as firing.

The finger patterns **36"** can be heated for various amounts of time to etch through the coating layer **32.** Typically, the finger patterns **36"** are heated only for the period of time required for the fingers **36** to uniformly contact the upper doped region **26.** Such times can be determined via routine experimentation. Unnecessarily overheating the fingers **36** for longer periods of time may damage the upper doped region **26** or other components of the PV cell **20.** After heating the finger patterns **36"** such that they can etch through the coating layer **32,** the method further comprises the step of applying a composition to at least a portion of the upper portions **40** of the fingers **36** to form the layer **44"** as described above.

Referring to Figure 7, the fingers **36** are formed in a different manner than as described above. The coating layer **32** can be formed as described above. After forming the coating layer **32,** holes **52** are formed therein. The holes **52** can be formed by various methods, such as by laser ablation, chemical etching, physical etching, etc. Such etching is different from the finger **36** "etching" described above. The fingers **36** are then formed in the holes **52.** These fingers **36** are generally the plated fingers **36** as described above. The fingers **36** can be formed by depositing various metals into the holes **52.** Various processes can be used, and different processes can be used for each layer of the fingers **36.** An electrochemical plating process may be used to form the layers in the holes **52.** Typically, such processes do not require a separate heating/firing step as described above. After forming the fingers **36,** the method further comprises the step of applying a composition to at least a portion of the upper portions **40** of the fingers **36** to form the layer **44"** as described above.

The busbar **44** is directly solderable, which is useful for tabbing multiple PV cells **20** together, such as by attaching ribbons or interconnects to the busbars **44** of the PV cells **20.** Said another way, typically there is no topcoat, protective, or outermost layer which needs to be removed from the busbar **44** prior to soldering directly thereto. This provides for reduced manufacturing time, complexity, and cost. For example, tabbing **50** can be directly soldered to the busbar **44** without the need for additional steps to be taken. An exception to this may be an additional fluxing step. In general, a surface is directly solderable if solder can be wet out on the surface after processing. For example, if one can either directly solder a wire to a substrate (within a commercially reasonable time frame and typically using an applied flux), use a tinned soldering iron to place a solder layer on the busbar, or simply heat up the substrate and see the solder wet out the electrode surface, the material would be directly solderable. In the case of a non-solderable system, even after applying flux and extensive heating, the solder never wets the surface, and no solder joint can be made. By using the busbar **44** and tabbing, it is possible to collect current from the fingers **36** effectively. As introduced above, the PV cell **20** may be used in various applications.

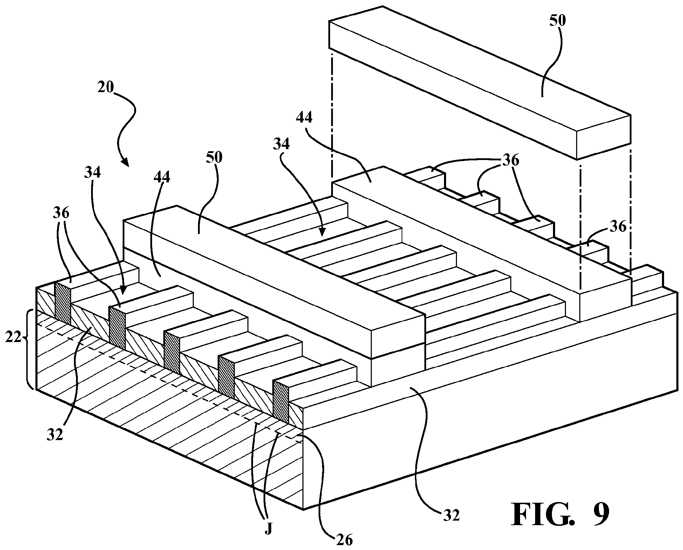

Referring to Figure 9, tabbing **50** is disposed on the busbars **44.** In certain examples, the tabbing **50** is directly solderable to the busbars **44** of the PV cells **20.** In other examples, additional solder (not shown) may be used between the busbars **44** and tabbing **50.** Fluxing means may be used to aid in soldering, such a flux pen or flux bed. The tabbing **50** itself may also include flux, such as Sn or Sn alloys and flux. The tabbing **50** can be formed from various materials, such as Cu, Sn, etc. Such tabbing **50** can be used to connect a series of PV cells **20.** For example, a PV cell module (not shown) can include a plurality of the PV cells **20.** Tabbing **50,** e.g. ribbon, is generally in physical contact with the busbars **44** of the PV cells **20** to electrically connect the PV cells **20** in series. The tabbing **50** may also be referred to in the art as an interconnection. The PV module may also include other components, such as tie layers, substrates, superstrates, and/or additional materials that provide strength and stability. In many applications, the PV cells **20** are encapsulated to provide additional protection from environmental factors such as wind and rain.

Various types of PV cells **20** utilizing the invention composition to form one or more structures/components, such as conductors, electrodes, and/or busbars formed from the invention composition, are described in co-pending PCT Application No. WO2013/090570, filed concurrently with the subject application.

In the examples immediately above and in other embodiments described herein, the invention composition generally comprises: a metal powder; a solder powder which has a lower melting temperature than a melting temperature of the metal powder; a polymer; a carboxylated-polymer different from the polymer for fluxing the metal powder and cross-linking the polymer; a dicarboxylic acid for fluxing the metal powder; and a monocarboxylic acid for fluxing the metal powder. The composition can optionally further comprise additives, such as a solvent and/or an adhesion promoter.

The metal powder can comprise copper, and the solder powder can have a melting temperature of no greater than about 300 °C. The solder powder can comprise at least one of a tin-bismuth (SnBi) alloy, a tin-silver (SnAg) alloy, or combinations thereof. In specific examples, the solder powder comprises at least one tin (Sn) alloy and no greater than 0.5 weight percent (wt%) of: mercury, cadmium, and/or chromium; and/or lead.

The metal and solder powders are collectively present in an amount of from about 50 to about 95 wt%; the metal powder is present in an amount of from about 35 to about 85 wt%; and/or the solder powder is present in any amount of from about 25 to about 75 wt%; each based on the total weight of the composition.

The polymer can comprise an epoxy resin, and the carboxylated-polymer can comprise an acrylic polymer, such as a styrene-acrylic copolymer. The polymer and the carboxylated-polymer are collectively present in an amount of from about 2.5 to about 10 wt%; the polymer is present in an amount of from about 0.5 to about 5 wt; and/or the carboxylated-polymer is present in an amount of from about 1 to about 7.5 wt%; each based on the total weight of the composition. In certain examples, the polymer and the carboxylated-polymer are in a weight ratio of from about 1:1 to about 1:3 (polymer:carboxylated-polymer).

The dicarboxylic acid can be dodecanedioic acid (DDDA) and the monocarboxylic acid can be neodecanoic acid. In various embodiments, the dicarboxylic acid present in an amount of from about 0.05 to about 1 wt%; and/or the monocarboxylic acid is present in an amount of from about 0.25 to about 1.25 wt%; each based on the total weight of the composition.

The following examples, illustrating the PV cell **20** and the method of the present invention are intended to illustrate the invention. The amount and type of each component used to form the compositions is indicated in Tables 1 through 3 below with all values in wt% based on a total weight of the respective composition unless otherwise indicated.

**Table 1**

| **Component (wt%)** | **Example** | | |
|---|---|---|---|
| | **1** | **2** | **3** |
| Second Metal 1 | 12.80 | 23.45 | 40.25 |
| Second Metal 2 | 34.63 | 26.81 | - |
| Third Metal 1 | 17.27 | 16.23 | 21.00 |
| Third Metal 2 | 12.10 | - | 23.76 |
| Third Metal 3 | 11.31 | 23.75 | - |
| Polymer 1 | 1.71 | 1.72 | - |
| Polymer 2 | - | - | - |
| Polymer 3 | 3.60 | 3.64 | 3.64 |
| Polymer 4 | - | - | 6.95 |
| Additive 1 | 1.98 | - | - |
| Additive 2 | - | 0.28 | 0.28 |
| Additive 3 | 1.00 | - | - |
| Additive 4 | 1.80 | 1.82 | 1.82 |
| Additive 5 | - | 0.48 | 0.48 |
| Additive 6 | 1.80 | 1.82 | 1.82 |
| **Total** | **100** | **100** | **100** |

Second Metal 1 is copper powder, commercially available from Mitsui Mining & Smelting Co. of Japan.
Second Metal 2 is a conventional silver powder, commercially available from Ferro.

Third Metal 1 is a Sn42/Bi58 alloy, having a melting temperature of about 221 °C, commercially available from Indium Corporation of America.
Third Metal 2 is a Sn63/Pb37 alloy, having a melting temperature of about 183 °C.
Third Metal 3 is a Sn96.5/Ag3.5 alloy, having a melting temperature of about 221 °C, commercially available from Indium Corporation of America.

Polymer 1 is a solid epoxy resin comprising the reaction product of epichlorohydrin and bisphenol A and having an epoxy equivalent weight (EEW) of 500-560 g/eq, commercially available from Dow Chemical of Midland, MI.
Polymer 2 is a silicone commercially available from Dow Corning Corp. of Midland, MI.
Polymer 3 is a low molecular weight styrene-acrylic copolymer having an acid value of about 238, on solids, commercially available from BASF Corp. of Florham Park, NJ.
Polymer 4 is a polyurethane resin commercially available from BASF Corp.

Additive 1 is a monoterpene alcohol, commercially available from Sigma Aldrich of Chicago, IL.
Additive 2 is a styrene dibromide, commercially available from Sigma Aldrich.
Additive 3 is dodecanedioic acid, commercially available from Sigma Aldrich.
Additive 4 is propylene glycol, commercially available from Sigma Aldrich.
Additive 5 is neodecanoic acid, commercially available from Hexion Specialty Chemicals of Carpentersville, IL.
Additive 6 is benzyl alcohol, commercially available from Sigma Aldrich.
Additive 7 is a titanate adhesion promoter, commercially available from Kenrich Petrochemicals Co.
Additive 8 is a silane adhesion promoter comprising 2-(3,4-epoxycyclohexyl) ethyltrimethoxysilane, commercially available from Dow Corning Corp.
Additive 9 is a butyl carbitol, commercially available from Dow Chemical.

**Table 2**

| **Component (wt%)** | **Example** | | | |
|---|---|---|---|---|
| | **4** | **5** | **6** | **7** |
| Second Metal 1 | 46.45 | 47.72 | 46.5600 | 47.83 |
| Second Metal 2 | - | - | - | - |
| Third Metal 1 | - | 15.63 | 16.2283 | 20.55 |
| Third Metal 2 | 40.01 | - | - | 20.45 |
| Third Metal 3 | - | 24.38 | 23.7501 | - |
| Polymer 1 | 2.45 | 1.76 | 1.7243 | 1.71 |
| Polymer 2 | 5.50 | - | - | - |
| Polymer 3 | - | 3.72 | 3.6362 | 3.60 |
| Polymer 4 | - | - | - | - |
| Additive 1 | 1.98 | 2.05 | 2.0050 | 1.98 |
| Additive 2 | - | 0.29 | 0.2807 | 0.28 |
| Additive 3 | - | 0.25 | 0.2432 | - |
| Additive 4 | 1.80 | 1.86 | 1.8185 | 1.80 |
| Additive 5 | - | 0.50 | 0.4840 | - |
| Additive 6 | 1.80 | 1.86 | 1.8185 | 1.80 |
| Additive 7 | - | - | 0.5567 | - |
| Additive 8 | - | - | 0.3036 | - |
| Additive 9 | - | - | 0.5907 | - |
| **Total** | **100** | **100** | **100** | **100** |

**Table 3**

| **Component (wt%)** | **Example** | | |
|---|---|---|---|
| | **8** | **9** | **10** |
| Second Metal 1 | 47.72 | 46.45 | 12.80 |
| Second Metal 2 | - | - | 34.63 |
| Third Metal 1 | 15.63 | - | 17.27 |
| Third Metal 2 | - | 40.01 | 12.10 |
| Third Metal 3 | 24.38 | - | 11.31 |
| Polymer 1 | - | - | 1.71 |
| Polymer 2 | - | 7.95 | - |
| Polymer 3 | - | - | 3.60 |
| Polymer 4 | 5.48 | - | - |
| Additive 1 | 2.05 | 1.98 | 1.98 |
| Additive 2 | 0.29 | - | - |
| Additive 3 | 0.25 | - | 1.00 |
| Additive 4 | 1.86 | 1.80 | 1.80 |
| Additive 5 | 0.50 | - | - |
| Additive 6 | 1.86 | 1.80 | 1.80 |
| **Total** | **100** | **100** | **100** |

A series of 5 inch (12.7 cm) monocrystalline silicon cells (wafers) are prepared for application of Ag and Cu pastes. The pastes according to the Examples above are prepared. Each of the pastes is diluted down with 1 wt% butyl carbitol to improve print rheology. Each of the pastes is printed on the wafers to form Cu busbars via a busbar screen from Sefar, a stainless steel screen 325 or 165 mesh, with a 12.7 µm emulsion thickness (PEF2), and a 22° or 45° rotation of the mesh. Printing is performed with an AMI screen printer with a -0.68 kg down force, with a 200 µm blank wafer on the stage. Print speed is set to between 3-5 inch/sec in a print-print mode. The wafers are printed and put through a BTU Pyramax N₂ reflow oven.

Durability of the Cu busbars under damp heat (DH; 85 °C, 85% relative humidity) aging conditions is determined. Unencapsulated prints of Cu busbars on silicon are used to monitor the Cu bulk resistivity (ρ). The quality of the tabbing/Cu busbars is also monitored using contact resistivity (ρ_{C}) utilizing the TLM method. With Example 5, after 1000 hours of exposure to DH, no degradation of the Cu busbars is seen relative to the Ag busbars.

Current-voltage (I-V) measurements using a flash tester (PSS 10 II) are performed. The Cu busbars according to Example 5 show increased V_{OC} and J_{SC} compared to the comparative Ag busbars. Specifically, cells including Cu busbars show a distinct improvement in V_{OC} and J_{SC}, relative to cells including Ag busbars. The increase generally corresponds to a 0.6% and 2.59% relative increase in V_{OC} and J_{SC}, respectively. It is believed that this increase is attributed to the reduction of metal/silicon contact area, as described above.

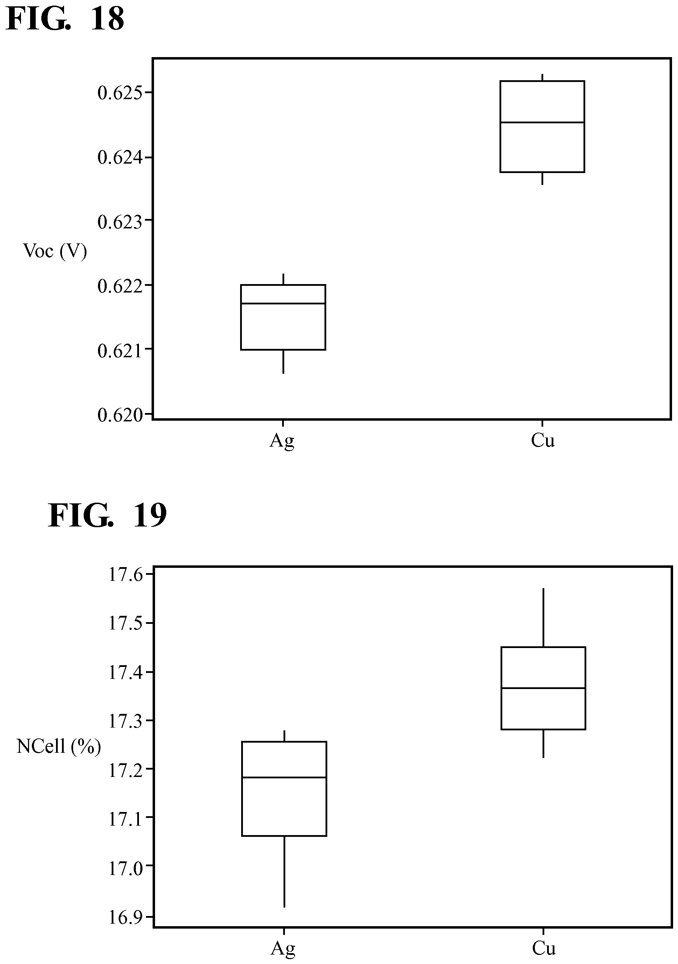

Another batch of screen printed Al BSF wafers is prepared with rear contact pads. The wafers include front Ag and front Cu prints all with rear Ag busbars. The Cu busbars are printed with the Cu paste according to Example 5 described above. The cells are tabbed manually and tested prior to encapsulation. The cells can be tabbed using typical industry tabbing. In these examples, tabbing can be performed by hand using a soldering iron at 390°C and flux. Front grid resistance is measured, along with I-V, and Suns Voc to determine quality of the cells and the metallization. The measurement results are shown in Figures 17 through 19. The batch shows an improved V_{OC} and J_{SC}, again attributed to a decrease in metal/silicon contact area.

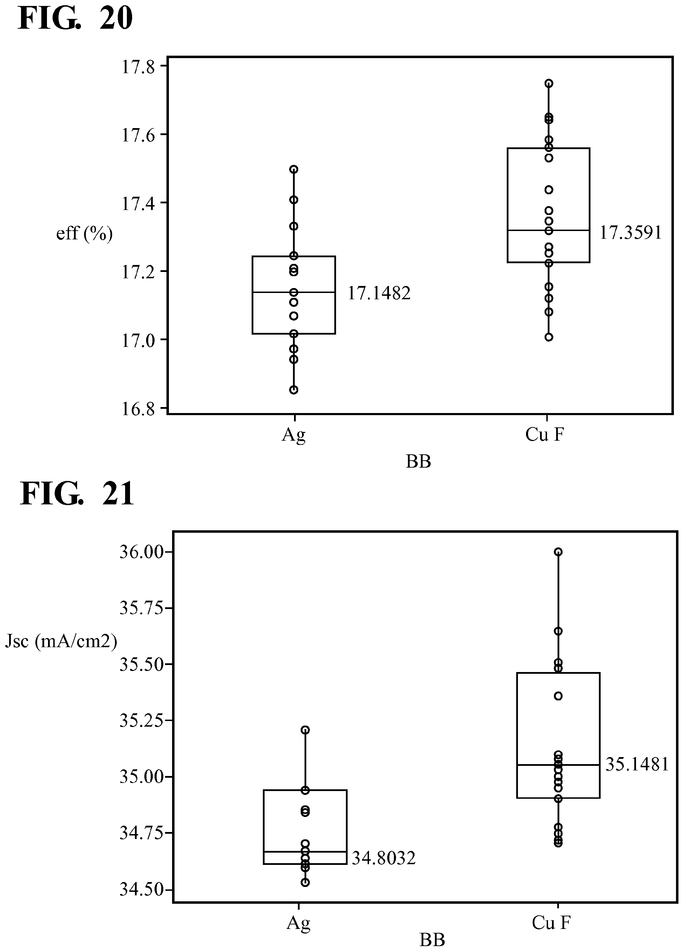

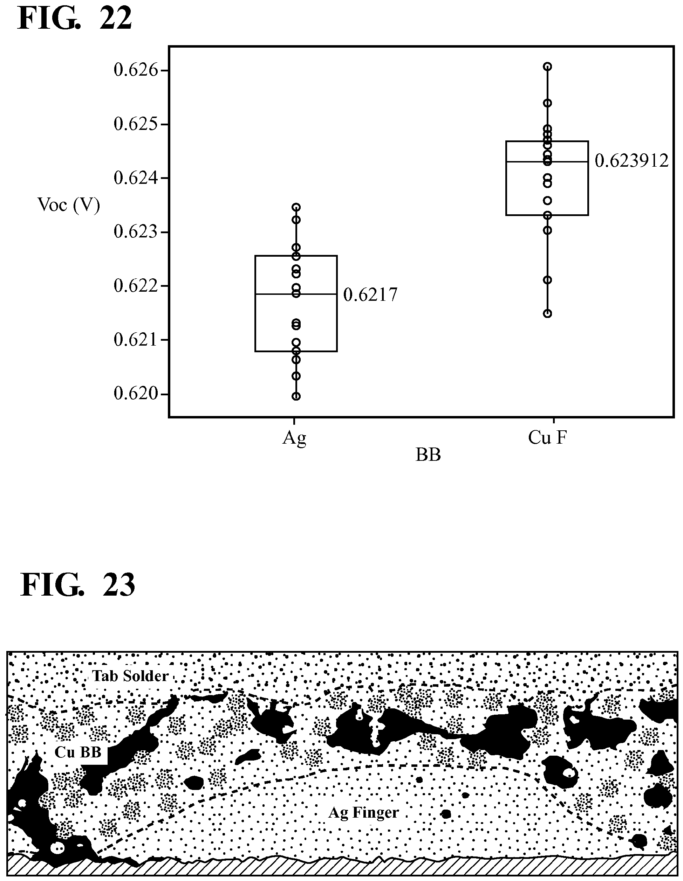

Referring to Figure 20, a box graph illustrating efficiency percentage of the comparative and invention PV cells is depicted, whereas Figure 21 illustrates J_{SC}, and Figure 22 illustrates V_{OC} of the examples. Specifically, IV data for samples is measured. Ag examples are 149-1 through -15, and Cu F examples are 149-A through -S. Mean values are shown. The comparative and invention examples are the same as described above in the previous example Figures. From the data, it is clearly shown that the use of the Cu busbar of the present invention has a distinct improvement in cell performance. This improvement is believed to come from the reduced recombination by reducing the metal/silicon interface area with reduced high temperature fired Ag metallization points.

Figure 23 is a cross-sectional optical microscopy photograph illustrating a tabbed busbar of the invention. Specifically, a Cu busbar is printed on top of a SiNx passivation layer and on top a Ag finger and later tabbed. Various components of the invention composition are shown in the cross-section. A direct solder bond to the tabbing/busbar and busbar/finger is shown, as well as the adhesive contact between the Cu busbar and the substrate.

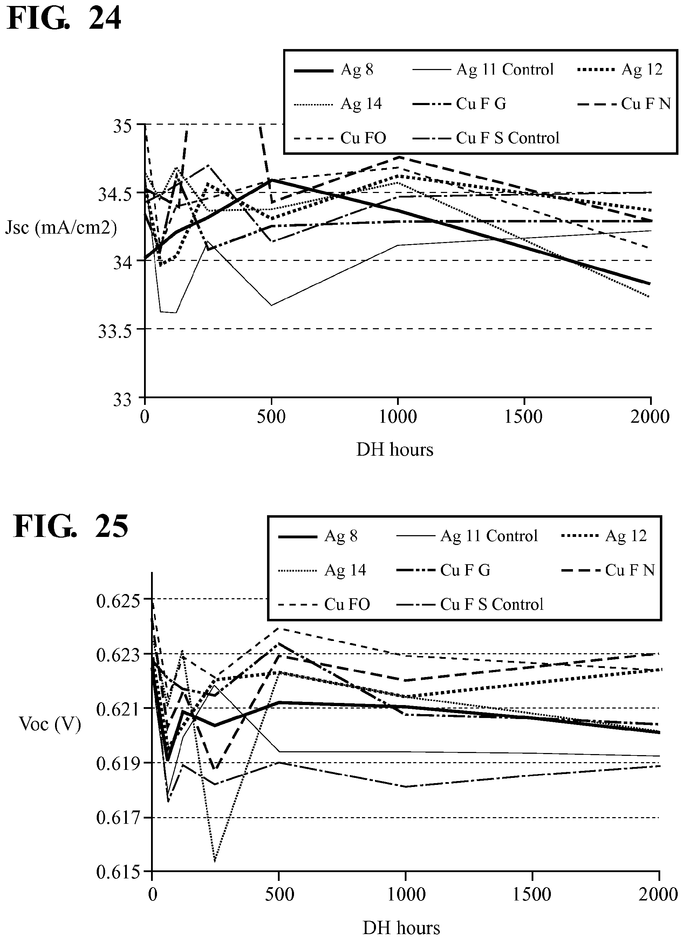

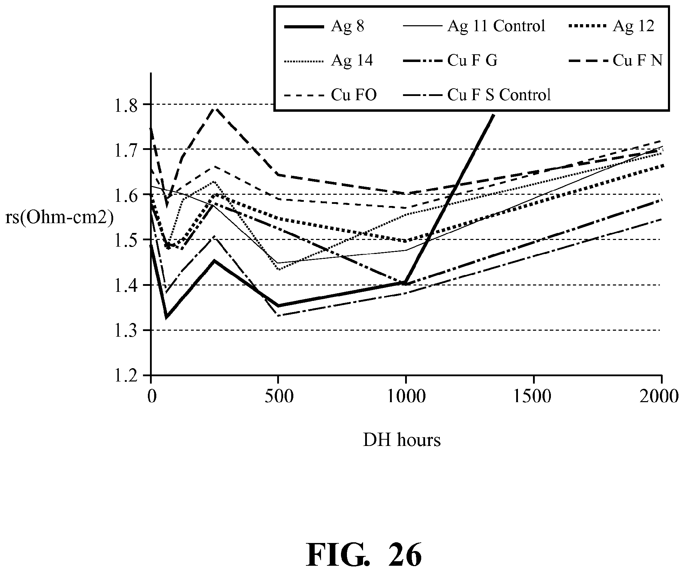

Figure 24 is a line graph illustrating J_{SC} of comparative and invention PV cell examples after damp heat aging. Figure 25 is a line graph illustrating V_{OC} of the comparative and invention PV cells after damp heat aging, and Figure 26 is a line graph illustrating sheet resistivity (rs) of the comparative and invention PV cell examples after damp heat aging. From these graphs it is clear that the Cu paste is not degrading performance under corrosive conditions.

One or more of the values described above may vary by ±5%, ±10%, ±15%, ±20%, ±25%, etc. so long as the variance remains within the scope of the claims. Unexpected results may be obtained from each member of a Markush group independent from all other members. Each member may be relied upon individually and or in combination and provides adequate support for specific embodiments within the scope of the appended claims.

## Claims

1. A photovoltaic cell (20) comprising:
a base substrate (22) comprising silicon and including an upper doped region (26);
a coating layer (32) disposed on said upper doped region (26) of said base substrate (22) and having an outer surface (34);
a plurality of fingers (36) spaced from each other and disposed in said coating layer (32) and each of said fingers (36) having a lower portion (38) in electrical contact with said upper doped region (26) of said base substrate (22), and an upper portion (40) opposite said lower portion (38) extending outwardly through said outer surface (34) of said coating layer (32), with each of said fingers (36) comprising a first metal present in each of said fingers (36) in a majority amount;
a busbar (44) spaced from said upper doped region (26) of said base substrate (22) such that said upper doped region (26) of said base substrate (22) is free of physical contact with said busbar (44), with said busbar (44) in electrical contact with said upper portions (40) of said fingers (36) and comprising a second metal present in said busbar (44) in a majority amount,
wherein said upper doped region (26) of said base substrate (22) is in electrical communication with said busbar (44) via said fingers (36), and **characterized in that** it further comprises:
i) a plurality of supplemental fingers (36b) disposed over and in electrical contact with said plurality of fingers (36), with each of said supplemental fingers (36b) comprising silver or copper present in each of said supplemental fingers (36b) in a majority amount, and wherein said supplemental fingers (36b) are different from said plurality of fingers (36);
ii) a supplemental busbar (44b) disposed over and in electrical contract with said busbar (44), and wherein said supplemental busbar (44b) is different from said busbar (44); or
iii) both i) and ii).

2. A photovoltaic cell (20) according to claim 1, wherein said busbar (44) is formed at a temperature of no greater than about 300 °C from a composition comprising said second metal and enabling said busbar (44) to be formed at said temperature.

3. A photovoltaic cell (20) according to claim 1, wherein said busbar (44) further comprises a third metal different from said first metal of said fingers (36) and said second metal of said busbar (44) with said third metal having a melting temperature of no greater than about 300 °C.

4. The photovoltaic cell (20) as set forth in any one of the preceding claims, wherein:
i) said base substrate (22) further includes a lower doped region (28) opposite said upper doped region (26);
ii) said upper doped region (26) of said base substrate (22) is an n-type doped region or a p-type doped region; or
iii) both i) and ii).

5. The photovoltaic cell (20) as set forth in any one of the preceding claims, wherein:
i) said busbar (44) is disposed on said outer surface (34) of said coating layer (32) and around each of said fingers (36) to physically and electrically contact said upper portions (40) of said fingers (36) with said coating layer (32) disposed between said busbar (44) and said upper doped region (26) of said base substrate (22);
ii) said coating layer (32) comprises SiOₓ, ZnS, MgFₓ, SiNₓ, SiCNₓ, AlOₓ, TiO₂, a transparent conducting oxide (TCO), or combinations thereof; or
iii) both i) and ii).

6. The photovoltaic cell (20) as set forth in any one of the preceding claims, wherein said first metal of said fingers (36) comprises silver or copper, said second metal of said busbar (44) comprises copper or silver, and said third metal of said busbar (44) comprises solder (48").

7. A photovoltaic cell (20) according to claim 1, wherein the photovoltaic cell (20) further includes:
an upper doped region (26) selected from an n-type doped region or a p-type doped region, and
a lower doped region (28) opposite said upper doped region (26); and
a coating layer (32) disposed on said upper doped region (26) of said base substrate (22) and having an outer surface (34) with said coating layer (32) comprising SiOₓ, ZnS, MgFₓ, SiNₓ, SiCNₓ, AlOₓ, TiO₂, a transparent conducting oxide (TCO), or combinations thereof.

8. The photovoltaic cell (20) as set forth in any one of the preceding claims, wherein said:
i) first metal of said fingers (36) is silver and said second metal of said busbar (44) is copper; and/or
ii) solder (48") comprises a tin alloy; and/or
iii) busbar (44) is directly solderable.

9. The photovoltaic cell (20) as set forth in any one of the preceding claims, wherein said busbar (44) is formed from a composition comprising;
a copper powder (46) as said second metal,
a solder powder (48") which melts at lower temperature than said copper powder (46) as said third metal, and
a polymer (45).

10. A photovoltaic cell module comprising a plurality of said photovoltaic cells (20) as set forth in any one of the preceding claims, and further comprising at least one ribbon (50) in physical contact with said busbars (44) of said photovoltaic cells (20) such that said photovoltaic cells (20) are in electrical communication with each other via said ribbon (50).

11. A method of forming a photovoltaic cell (20) comprising a base substrate (22) comprising silicon and including an upper doped region (26), a coating layer (32) disposed on the upper doped region (26), and further comprising a plurality of fingers (36) spaced from each other and disposed in the coating layer (32) and in electrical contact with the upper doped region (26) of the base substrate (22) and comprising a first metal present in each of the fingers (36) in a majority amount, and a busbar (44) spaced from the upper doped region (26) and in electrical contact with the fingers (36), the photovoltaic cell (20) further comprising,
i) a plurality of supplemental fingers (36b) disposed over and in electrical contact with said plurality of fingers (36), with each of said supplemental fingers (36b) comprising silver or copper present in each of said supplemental fingers (36b) in a majority amount, and wherein said supplemental fingers (36b) are different from said plurality of fingers (36);
ii) a supplemental busbar (44b) disposed over and in electrical contract with said busbar (44), and wherein said supplemental busbar (44b) is different from said busbar (44); or
iii) both i) and ii)[[.]];
said method comprising the steps of:
applying a composition comprising a second metal present in the composition in a majority amount and a third metal to at least a portion of the upper portions (40) of the fingers (36) to form a layer (44") such that the upper doped region (26) of the base substrate (22) is free of physical contact with the layer (44"); and
heating the layer (44") to a temperature of no greater than about 300 °C to form the busbar (44);
wherein the third metal of the busbar (44) is different from the first metal of the fingers (36) and the second metal of the composition; and
wherein the upper doped region (26) of the base substrate (22) is in electrical communication with the busbar (44) via the fingers (36).

12. The method as set forth in claim 11, wherein the first metal of the fingers (36) comprises silver or copper, the second metal of the composition comprises copper or silver, and the third metal of the composition comprises solder (48").

13. The method as set forth in claim 11 or 12, wherein applying the composition is further defined as printing the composition on the upper portions (40) of the fingers (36) to define the busbar (44).

14. The method as set forth in any one of claims 11 through 13, wherein the composition comprises;
a copper powder (46) as the second metal,
a solder powder (48") which melts at lower temperature than melting temperature of the copper powder (46), as the third metal, and
a polymer (45").

## Patentansprüche

1. Eine Photovoltaikzelle (20), die Folgendes beinhaltet:
ein Basissubstrat (22), das Silicium beinhaltet und eine obere dotierte Region (26) umfasst;
eine Überzugsschicht (32), die auf der oberen dotierten Region (26) des Basissubstrats (22) angeordnet ist und eine äußere Oberfläche (34) aufweist;
eine Vielzahl von Fingern (36), die voneinander beabstandet sind und in der Überzugsschicht (32) angeordnet sind, und wobei jeder der Finger (36) einen unteren Abschnitt (38) in elektrischem Kontakt mit der oberen dotierten Region (26) des Basissubstrats (22) und einen dem unteren Abschnitt (38) entgegengesetzten oberen Abschnitt (40), der sich durch die äußere Oberfläche (34) der Überzugsschicht (32) nach außen erstreckt, aufweist, wobei jeder der Finger (36) ein erstes Metall beinhaltet, das in jedem der Finger (36) in einer Mehrheitsmenge vorhanden ist;
eine Sammelschiene (44), die von der oberen dotierten Region (26) des Basissubstrats (22) beabstandet ist, sodass die obere dotierte Region (26) des Basissubstrats (22) keinen physischen Kontakt mit der Sammelschiene (44) hat, wobei die Sammelschiene (44) mit den oberen Abschnitten (40) der Finger (36) in elektrischem Kontakt steht und ein zweites Metall beinhaltet, das in der Sammelschiene (44) in einer Mehrheitsmenge vorhanden ist,
wobei die obere dotierte Region (26) des Basissubstrats (22) über die Finger (36) mit der Sammelschiene (44) in elektrischer Kommunikation steht, und
**dadurch gekennzeichnet ist, dass** sie ferner Folgendes beinhaltet:
i) eine Vielzahl von zusätzlichen Fingern (36b), die über und in elektrischem Kontakt mit der Vielzahl von Fingern (36) angeordnet sind, wobei jeder der zusätzlichen Finger (36b) Silber oder Kupfer beinhaltet, das in jedem der zusätzlichen Finger (36b) in einer Mehrheitsmenge vorhanden ist, und wobei sich die zusätzlichen Finger (36b) von der Vielzahl von Fingern (36) unterscheiden;
ii) eine zusätzliche Sammelschiene (44b), die über und in elektrischem Kontakt mit der Sammelschiene (44) angeordnet ist, und wobei sich die zusätzliche Sammelschiene (44b) von der Sammelschiene (44) unterscheidet; oder
iii) sowohl i) als auch ii).

2. Photovoltaikzelle (20) gemäß Anspruch 1,
wobei die Sammelschiene (44) bei einer Temperatur von nicht mehr als etwa 300 °C aus einer Zusammensetzung gebildet wird, die das zweite Metall beinhaltet und es ermöglicht, die Sammelschiene (44) bei dieser Temperatur zu bilden.

3. Photovoltaikzelle (20) gemäß Anspruch 1,
wobei die Sammelschiene (44) ferner ein drittes Metall beinhaltet, das sich von dem ersten Metall der Finger (36) und dem zweiten Metall der Sammelschiene (44) unterscheidet, wobei das dritte Metall eine Schmelztemperatur von nicht mehr als etwa 300 °C aufweist.

4. Photovoltaikzelle (20) gemäß einem der vorhergehenden Ansprüche, wobei:
i) das Basissubstrat (22) ferner eine der oberen dotierten Region (26) entgegengesetzte untere dotierte Region (28) umfasst;
ii) die obere dotierte Region (26) des Basissubstrats (22) eine n-dotierte Region oder eine p-dotierte Region ist; oder
iii) sowohl i) als auch ii).

5. Photovoltaikzelle (20) gemäß einem der vorhergehenden Ansprüche, wobei:
i) die Sammelschiene (44) auf der äußeren Oberfläche (34) der Überzugsschicht (32) und um jeden der Finger (36) angeordnet ist, um physisch und elektrisch mit den oberen Abschnitten (40) der Finger (36) in Kontakt zu stehen, wobei die Überzugsschicht (32) zwischen der Sammelschiene (44) und der oberen dotierten Region (26) des Basissubstrats (22) angeordnet ist;
ii) die Überzugsschicht (32) SiOₓ, ZnS, MgFₓ, SiNₓ, SiCNₓ, AlOₓ, TiO₂, ein transparentes leitfähiges Oxid (TCO) oder Kombinationen davon beinhaltet; oder
iii) sowohl i) als auch ii).

6. Photovoltaikzelle (20) gemäß einem der vorhergehenden Ansprüche, wobei das erste Metall der Finger (36) Silber oder Kupfer beinhaltet, das zweite Metall der Sammelschiene (44) Kupfer oder Silber beinhaltet und das dritte Metall der Sammelschiene (44) Lötmetall (48") beinhaltet.

7. Photovoltaikzelle (20) gemäß Anspruch 1, wobei die Photovoltaikzelle (20) ferner Folgendes umfasst:
eine obere dotierte Region (26), die aus einer n-dotierten Region und einer p-dotierten Region ausgewählt ist; und
eine der oberen dotierten Region (26) entgegengesetzte untere dotierte Region (28); und
eine Überzugsschicht (32), die auf der oberen dotierten Region (26) des Basissubstrats (22) angeordnet ist und eine äußere Oberfläche (34) aufweist, wobei die Überzugsschicht (32) SiOₓ, ZnS, MgFₓ, SiNₓ, SiCNₓ, AlOₓ, TiO₂, ein transparentes leitfähiges Oxid (TCO) oder Kombinationen davon beinhaltet.

8. Photovoltaikzelle (20) gemäß einem der vorhergehenden Ansprüche, wobei:
i) das erste Metall der Finger (36) Silber ist und das zweite Metall der Sammelschiene (44) Kupfer ist; und/oder
ii) das Lötmetall (48") eine Zinnlegierung beinhaltet; und/oder
iii) die Sammelschiene (44) direkt gelötet werden kann.

9. Photovoltaikzelle (20) gemäß einem der vorhergehenden Ansprüche, wobei die Sammelschiene (44) aus einer Zusammensetzung gebildet ist, die Folgendes beinhaltet:
ein Kupferpulver (46) als das zweite Metall,
ein Lötmetallpulver (48"), das bei einer niedrigeren Temperatur schmilzt als das Kupferpulver (46), als das dritte Metall, und
ein Polymer (45).

10. Ein Photovoltaikzellmodul, das eine Vielzahl der Photovoltaikzellen (20) gemäß einem der vorhergehenden Ansprüche beinhaltet, und das ferner mindestens ein Band (50) in physischem Kontakt mit den Sammelschienen (44) der Photovoltaikzellen (20) beinhaltet, sodass die Photovoltaikzellen (20) miteinander über das Band (50) in elektrischer Kommunikation stehen.

11. Ein Verfahren zum Bilden einer Photovoltaikzelle (20), die Folgendes beinhaltet: ein Basissubstrat (22), das Silicium beinhaltet und eine obere dotierte Region (26) umfasst, eine Überzugsschicht (32), die auf der oberen dotierten Region (26) angeordnet ist, und ferner Folgendes beinhaltet: eine Vielzahl von Fingern (36), die voneinander beabstandet sind und in der Überzugsschicht (32) und in elektrischem Kontakt mit der oberen dotierten Region (26) des Basissubstrats (22) angeordnet sind und ein erstes Metall beinhalten, das in jedem der Finger (36) in einer Mehrheitsmenge vorhanden ist, und eine Sammelschiene (44), die von der oberen dotierten Region (26) beabstandet ist und mit den Fingern (36) in elektrischem Kontakt steht, wobei die Photovoltaikzelle (20) ferner Folgendes beinhaltet:
i) eine Vielzahl von zusätzlichen Fingern (36b), die über und in elektrischem Kontakt mit der Vielzahl von Fingern (36) angeordnet sind, wobei jeder der zusätzlichen Finger (36b) Silber oder Kupfer beinhaltet, das in jedem der zusätzlichen Finger (36b) in einer Mehrheitsmenge vorhanden ist, und wobei sich die zusätzlichen Finger (36b) von der Vielzahl von Fingern (36) unterscheiden;
ii) eine zusätzliche Sammelschiene (44b), die über und in elektrischem Kontakt mit der Sammelschiene (44) angeordnet ist, und wobei sich die zusätzliche Sammelschiene (44b) von der Sammelschiene (44) unterscheidet; oder
iii) sowohl i) als auch ii);
wobei das Verfahren die folgenden Schritte beinhaltet:
Aufbringen einer Zusammensetzung, die ein zweites Metall, das in der Zusammensetzung in einer Mehrheitsmenge vorhanden ist, und ein drittes Metall beinhaltet, auf mindestens einen Abschnitt der oberen Abschnitte (40) der Finger (36), um eine Schicht (44") zu bilden, sodass die obere dotierte Region (26) des Basissubstrats (22) keinen physischen Kontakt mit der Schicht (44") hat; und
Erwärmen der Schicht (44") auf eine Temperatur von nicht mehr als etwa 300 °C, um die Sammelschiene (44) zu bilden;
wobei sich das dritte Metall der Sammelschiene (44) von dem ersten Metall der Finger (36) und dem zweiten Metall der Zusammensetzung unterscheidet; und
wobei die obere dotierte Region (26) des Basissubstrats (22) über die Finger (36) mit der Sammelschiene (44) in elektrischer Kommunikation steht.

12. Verfahren gemäß Anspruch 11, wobei das erste Metall der Finger (36) Silber oder Kupfer beinhaltet, das zweite Metall der Zusammensetzung Kupfer oder Silber beinhaltet und das dritte Metall der Zusammensetzung Lötmetall (48") beinhaltet.

13. Verfahren gemäß Anspruch 11 oder 12, wobei das Aufbringen der Zusammensetzung ferner als Drucken der Zusammensetzung auf die oberen Abschnitte (40) der Finger (36) zum Definieren der Sammelschiene (44) definiert ist.

14. Verfahren gemäß einem der Ansprüche 11 bis 13, wobei die Zusammensetzung Folgendes beinhaltet:
ein Kupferpulver (46) als das zweite Metall,
ein Lötmetallpulver (48"), das bei einer niedrigeren Temperatur als der Schmelztemperatur des Kupferpulvers (46) schmilzt, als das dritte Metall, und ein Polymer (45").

## Revendications

1. Une cellule photovoltaïque (20) comprenant :
un substrat de base (22) comprenant du silicium et incluant une région dopée supérieure (26) ;
une couche de revêtement (32) disposée sur ladite région dopée supérieure (26) dudit substrat de base (22) et ayant une surface externe (34) ;
une pluralité de doigts (36) espacés les uns par rapport aux autres et disposés dans ladite couche de revêtement (32) et chacun desdits doigts (36) ayant une partie inférieure (38) en contact électrique avec ladite région dopée supérieure (26) dudit substrat de base (22), et une partie supérieure (40) à l'opposé de ladite partie inférieure (38) s'étendant vers l'extérieur à travers ladite surface externe (34) de ladite couche de revêtement (32), avec chacun desdits doigts (36) comprenant un premier métal présent dans chacun desdits doigts (36) dans une quantité majoritaire ;
une barre omnibus (44) espacée par rapport à ladite région dopée supérieure (26) dudit substrat de base (22) de telle sorte que ladite région dopée supérieure (26) dudit substrat de base (22) soit exempte de contact physique avec ladite barre omnibus (44), avec ladite barre omnibus (44) en contact électrique avec lesdites parties supérieures (40) desdits doigts (36) et comprenant un deuxième métal présent dans ladite barre omnibus (44) dans une quantité majoritaire,
dans laquelle ladite région dopée supérieure (26) dudit substrat de base (22) est en communication électrique avec ladite barre omnibus (44) par l'intermédiaire desdits doigts (36), et
**caractérisée en ce qu'**elle comprend en outre :
i) une pluralité de doigts supplémentaires (36b) disposés par-dessus et en contact électrique avec ladite pluralité de doigts (36), avec chacun desdits doigts supplémentaires (36b) comprenant de l'argent ou du cuivre présent dans chacun desdits doigts supplémentaires (36b) dans une quantité majoritaire, et chacun desdits doigts supplémentaires (36b) étant différent de ladite pluralité de doigts (36) ;
ii) une barre omnibus supplémentaire (44b) disposée par-dessus et en contact électrique avec ladite barre omnibus (44), et ladite barre omnibus supplémentaire (44b) étant différente de ladite barre omnibus (44) ; ou
iii) à la fois i) et ii).

2. Une cellule photovoltaïque (20) selon la revendication 1,
dans laquelle ladite barre omnibus (44) est formée à une température non supérieure à environ 300 °C à partir d'une composition comprenant ledit deuxième métal et permettant à ladite barre omnibus (44) d'être formée à ladite température.

3. Une cellule photovoltaïque (20) selon la revendication 1,
dans laquelle ladite barre omnibus (44) comprend en outre un troisième métal différent dudit premier métal desdits doigts (36) et dudit deuxième métal de ladite barre omnibus (44) avec ledit troisième métal ayant une température de fusion non supérieure à environ 300 °C.

4. La cellule photovoltaïque (20) telle qu'exposée dans n'importe laquelle des revendications précédentes, dans laquelle :
i) ledit substrat de base (22) inclut en outre une région dopée inférieure (28) à l'opposé de ladite région dopée supérieure (26) ;
ii) ladite région dopée supérieure (26) dudit substrat de base (22) est une région dopée de type n ou une région dopée de type p ; ou
iii) à la fois i) et ii).

5. La cellule photovoltaïque (20) telle qu'exposée dans n'importe laquelle des revendications précédentes, dans laquelle :
i) ladite barre omnibus (44) est disposée sur ladite surface externe (34) de ladite couche de revêtement (32) et autour de chacun desdits doigts (36) afin d'entrer en contact physiquement et électriquement avec lesdites parties supérieures (40) desdits doigts (36) avec ladite couche de revêtement (32) disposée entre ladite barre omnibus (44) et ladite région dopée supérieure (26) dudit substrat de base (22) ;
ii) ladite couche de revêtement (32) comprend SiOₓ, ZnS, MgFₓ, SiNₓ, SiCNₓ, AlOₓ, TiO₂, un oxyde transparent et conducteur (TCO), ou des combinaisons de ceux-ci ; ou
iii) à la fois i) et ii).

6. La cellule photovoltaïque (20) telle qu'exposée dans n'importe laquelle des revendications précédentes, dans laquelle ledit premier métal desdits doigts (36) comprend de l'argent ou du cuivre, ledit deuxième métal de ladite barre omnibus (44) comprend du cuivre ou de l'argent, et ledit troisième métal de ladite barre omnibus (44) comprend une brasure (48").

7. Une cellule photovoltaïque (20) selon la revendication 1, la cellule photovoltaïque (20) incluant en outre :
une région dopée supérieure (26) sélectionnée parmi une région dopée de type n ou
une région dopée de type p, et
une région dopée inférieure (28) à l'opposé de ladite région dopée supérieure (26) ; et
une couche de revêtement (32) disposée sur ladite région dopée supérieure (26) dudit substrat de base (22) et ayant une surface externe (34) avec ladite couche de revêtement (32) comprenant SiOₓ, ZnS, MgFx, SiNₓ, SiCNₓ, AlOₓ, TiO₂, un oxyde transparent et conducteur (TCO), ou des combinaisons de ceux-ci.

8. La cellule photovoltaïque (20) telle qu'exposée dans n'importe laquelle des revendications précédentes, dans laquelle :
i) ledit premier métal desdits doigts (36) est de l'argent et ledit deuxième métal de ladite barre omnibus (44) est du cuivre ; et/ou
ii) ladite brasure (48") comprend un alliage d'étain ; et/ou
iii) ladite barre omnibus (44) peut être directement brasurée.

9. La cellule photovoltaïque (20) telle qu'exposée dans n'importe laquelle des revendications précédentes, dans laquelle ladite barre omnibus (44) est formée à partir d'une composition comprenant :
une poudre de cuivre (46) en tant que dit deuxième métal,
une poudre de brasure (48") qui fond à une température inférieure à ladite poudre de cuivre (46) en tant que dit troisième métal, et
un polymère (45).

10. Un module de cellule photovoltaïque comprenant une pluralité desdites cellules photovoltaïques (20) telles qu'exposées dans n'importe laquelle des revendications précédentes, et comprenant en outre au moins un ruban (50) en contact physique avec lesdites barres omnibus (44) desdites cellules photovoltaïques (20) de telle sorte que lesdites cellules photovoltaïques (20) soient en communication électrique les unes avec les autres par l'intermédiaire dudit ruban (50).

11. Un procédé de formation d'une cellule photovoltaïque (20) comprenant un substrat de base (22) comprenant du silicium et incluant une région dopée supérieure (26), une couche de revêtement (32) disposée sur la région dopée supérieure (26), et comprenant en outre une pluralité de doigts (36) espacés les uns par rapport aux autres et disposés dans la couche de revêtement (32) et en contact électrique avec la région dopée supérieure (26) du substrat de base (22) et comprenant un premier métal présent dans chacun des doigts (36) dans une quantité majoritaire, et une barre omnibus (44) espacée par rapport à la région dopée supérieure (26) et en contact électrique avec les doigts (36), la cellule photovoltaïque (20) comprenant en outre,
i) une pluralité de doigts supplémentaires (36b) disposés par-dessus et en contact électrique avec ladite pluralité de doigts (36), avec chacun desdits doigts supplémentaires (36b) comprenant de l'argent ou du cuivre présent dans chacun desdits doigts supplémentaires (36b) dans une quantité majoritaire, et chacun desdits doigts supplémentaires (36b) étant différent de ladite pluralité de doigts (36) ;
ii) une barre omnibus supplémentaire (44b) disposée par-dessus et en contact électrique avec ladite barre omnibus (44), et ladite barre omnibus supplémentaire (44b) étant différente de ladite barre omnibus (44) ; ou
iii) à la fois i) et ii)[[.]] ;
ledit procédé comprenant les étapes consistant à :
appliquer une composition comprenant un deuxième métal présent dans la composition dans une quantité majoritaire et un troisième métal sur au moins une partie des parties supérieures (40) des doigts (36) afin de former une couche (44") de telle sorte que la région dopée supérieure (26) du substrat de base (22) soit exempte de contact physique avec la couche (44") ; et
chauffer la couche (44 ") à une température non supérieure à environ 300 °C afin de former la barre omnibus (44) ;
dans laquelle le troisième métal de la barre omnibus (44) est différent du premier métal des doigts (36) et du deuxième métal de la composition ; et
dans laquelle la région dopée supérieure (26) du substrat de base (22) est en communication électrique avec la barre omnibus (44) par l'intermédiaire des doigts (36).

12. Le procédé tel qu'exposé dans la revendication 11, dans lequel le premier métal des doigts (36) comprend de l'argent ou du cuivre, le deuxième métal de la composition comprend du cuivre ou de l'argent, et le troisième métal de la composition comprend une brasure (48").

13. Le procédé tel qu'exposé dans la revendication 11 ou la revendication 12, dans lequel l'application de la composition est en outre définie comme l'impression de la composition sur les parties supérieures (40) des doigts (36) afin de définir la barre omnibus (44).

14. Le procédé tel qu'exposé dans n'importe lesquelles des revendications 11 à 13, dans lequel la composition comprend :
une poudre de cuivre (46) en tant que deuxième métal,
une poudre de brasure (48") qui fond à une température inférieure à la température de fusion de la poudre de cuivre (46), en tant que troisième métal, et
un polymère (45").
